# EUROPEAN PATENT SPECIFICATION

(11) **EP 3 496 384 B1**
(45) Date of publication and mention of the grant of the patent: **15.07.2020**
(21) Application number: 18202916.5
(22) Date of filing: 26.10.2018
(51) Int. Cl.: H04N 5/225, G02B 26/00, G02C 7/08, G02B 3/14, G02B 13/00

(54) **ELECTRONIC DEVICE HAVING CAMERA DEVICE**
ELEKTRONISCHE VORRICHTUNG MIT KAMERAVORRICHTUNG
DISPOSITIF ÉLECTRONIQUE DOTÉ D'UN DISPOSITIF DE CAMÉRA

(30) Priority: 07.12.2017 US 201762595592 P; 04.05.2018 KR 20180051961
(43) Date of publication of application: 12.06.2019
(73) Proprietor: LG Electronics Inc., Seoul 07336 (KR)
(72) Inventor: KANG, Byeongkil, Seoul 06772 (KR); KIM, Jongpil, Seoul 06772 (KR); KIM, Namhee, Seoul 06772 (KR); KIM, Hakhae, Seoul 06772 (KR); JOO, Sungbum, Seoul 06772 (KR)
(74) Representative: Schornack, Oliver

(56) References cited:
- EP-A1- 2 009 468
- EP-A1- 2 071 367
- US-A1- 2008 267 603
- US-A1- 2017 315 274

## Description

### BACKGROUND OF THE INVENTION

### 1. Field of the Invention

The present disclosure relates to an electronic device having a camera device reduced in width.

### 2. Discussion of the Related Art

Terminals may be divided into a mobile terminal (mobile/portable terminal) and a stationary terminal. The mobile terminal may be divided into a handheld terminal and a vehicle mounted terminal.

The functions of mobile terminals are diversified. For example, there are functions of data and voice communication, photographing and video shooting through a camera, voice recording, music file playback through a speaker system, and outputting an image or video to a display unit. Some terminals are equipped with an electronic game play function or a multimedia player function. In particular, modern mobile terminals may receive multicast signals that provide visual content such as broadcast, video or television programs.

As functions are diversified, terminals are implemented in the form of multimedia devices supporting composite functions such as photographing or video shooting, music or video file playback, playing games, receiving broadcast, and the like. Further, in order to support and enhance the functions of the terminal, improvement of a structural and/or software part of the terminal may be considered.

In recent years, as various functions of electronic devices such as a mobile terminal and a fixed terminal have been developed, technical research have been conducted to minimize an area occupied by a bezel portion in order to increase the area of a display unit. However, since a plurality of electronic components are disposed in the bezel portion, there is a limitation in a reduction of the bezel portion as long as the volume of the electronic components is maintained.

US 2017/0315274 A1 refers to a lens assembly including a first lens unit, a liquid lens unit, a base, a printed circuit board, and a cover member. The printed circuit board is connectable to the liquid lens unit, and at least a portion of the printed circuit board is insertable into the base through an insertion hole. Terminals provided at both ends of the printed circuit board are bendable so as to be mounted in the cover member.

Each of EP 2 009 468 A1 and EP 2 071 367 A1 refers to a lens which comprises a first window and a second transparent window arranged in parallel and facing each other, and delimiting, in part, an internal volume containing two immiscible liquids. In EP 2 009 468 A1, the structure of the lens that contains the liquids comprises a cap to which the first transparent window is fixed, and a body which comprises: a recessed region for receiving the first window, and an annular foot protruding from the underside of the body for connection of the body to a voltage supply. In
EP 2 071 367 A1, the transparent windows are glued to an underside and a top side of an annular body, respectively.

US 2008/0267603 A1 refers to a camera module power supply unit which comprises a flexible substrate including a first flexible substrate stacked and disposed between an inner surface of a lens barrel and an outer surface of a base.

### SUMMARY OF THE INVENTION

Therefore, an aspect of the detailed description is to provide a camera device having a shape deformed to be disposed in a reduced bezel portion and an electronic device having the same. Such camera device and electronic device according to the present invention are defined by claims 1 and 13, respectively. Preferred embodiments are defined by the dependent claims.

According to one aspect of the present invention, a portion not used for forming an image in a liquid lens is utilized as a support region of a certain component.

To achieve these and other advantages and in accordance with the purpose of this specification, as embodied and broadly described herein, a camera device may include: a first lens unit concentrating light incident from a front side; a liquid lens unit disposed on a rear side of the first lens unit and controlling an optical path of light by adjusting curvature according to an electrical signal; a second lens unit disposed on a rear side of the liquid lens unit; an image sensor on which light passing through the second lens unit forms an image; and a flexible printed circuit board (FPCB) transferring the electrical signal to the liquid lens unit, wherein the liquid lens unit may include a first region allowing light, which is to form an image on the image sensor, to be transmitted therethrough and a second region surrounding the first region and the FPCB may be disposed in the second region and overlaps the liquid lens unit in a thickness direction. According to this structure, a width occupied by the FPCB may be reduced, minimizing a lateral thickness of the camera device.

The FPCB may surround the first region of the liquid lens unit while being disposed in the second region of the liquid lens unit.

The liquid lens unit may have an upper surface and a lower surface, and the FPCB may be stacked on the upper surface or the lower surface.

The camera device may further include a masking portion formed on the FPCB to surround the first region.

To achieve these and other advantages and in accordance with the purpose of this specification, as embodied and broadly described herein, a camera device may include: a lens assembly disposed inside the lens cover and including a liquid lens unit controlling an optical path of light incident from a front side according to an applied electrical signal; an image sensor overlapping the lens assembly and forming an image using light passing through the lens assembly; and an FPCB transferring the electrical signal to the liquid lens unit, wherein the liquid lens unit may include a first region allowing light, which is to form an image on the image sensor, to be transmitted therethrough and a second region surrounding the first region, and the FPCB may be disposed in the second region and overlaps the liquid lens unit in a thickness direction.

To achieve these and other advantages and in accordance with the purpose of this specification, as embodied and broadly described herein, an electronic device may include: a display unit; a bezel portion surrounding the display unit; and a camera device disposed in the bezel portion, wherein the camera device may include: a lens cover forming an appearance of the camera device and having a pair of flat surfaces facing each other and a lens assembly disposed inside the lens cover and including a liquid lens unit controlling an optical path of light incident from a front side according to an applied electrical signal; an image sensor overlapping the lens assembly and forming an image using light passing through the lens assembly; and an FPCB transferring the electrical signal to the liquid lens unit, wherein the liquid lens unit may include a first region allowing light, which is to form an image on the image sensor, to be transmitted therethrough and a second region surrounding the first region, the FPCB may be disposed in the second region and overlap the liquid lens unit in a thickness direction, and one of the pair of flat surfaces facing each other may be disposed to be adjacent to the display unit.

Effects of the camera device and the electronic device having the camera device according to the present invention will be described as follows. Since the FPCB for applying an electrical signal to the liquid lens unit is disposed to overlap the liquid lens unit in the thickness direction, the width of the camera device may be reduced.

According to at least one of the embodiments of the present invention, since the outer surface of the camera device is formed to be flat, a space between the display unit and the outer edge of the terminal body and the camera device can be minimized to reduce the thickness of the bezel portion. In addition, the camera device in which a flare phenomenon is reduced by the masking portion formed on the FPCB can be provided.

An additional scope of applicability of the present invention shall become obvious from the detailed description in the following. It is to be understood that both the foregoing general description and the following detailed description of the preferred embodiments of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments and together with the description serve to explain the principles of the invention.

In the drawings:
FIG. 1A is a block diagram illustrating a mobile terminal according to the present disclosure.
FIGS. 1B and 1C are conceptual views illustrating an example of a mobile terminal according to the present disclosure, viewed in different directions.
FIG. 2A is a view of a camera device viewed in one direction.
FIG. 2B is a cross-sectional view of the camera device of FIG. 2A, taken along line A-A.
FIG. 3 is a conceptual view illustrating a liquid lens.
FIG. 4A is a plan view illustrating a liquid lens unit in which a flexible printed circuit board (FPCB) of the present disclosure is positioned.
FIG. 4B is a side view of a liquid lens unit in which the FPCB illustrated in FIG. 4B is positioned.
FIGS. 5A and 5B are conceptual views illustrating an example of a liquid lens unit in which the FPCB illustrated in FIG. 4A is positioned.
FIGS. 6A, 6B and 6C are conceptual views illustrating another example of a liquid lens unit in which the FPCB illustrated in FIG. 4A is positioned.
FIG. 7 is a conceptual view illustrating a modification of a liquid lens unit in which the FPCB illustrated in FIG. 4A is positioned.
FIGS. 8A and 8B are conceptual views illustrating another modification of a liquid lens unit in which the FPCB illustrated in FIG. 4A is positioned.
FIG. 9 is a conceptual view illustrating an infrared cut filter according to the present disclosure.

### DETAILED DESCRIPTION OF THE INVENTION

Description will now be given in detail according to exemplary embodiments disclosed herein, with reference to the accompanying drawings. For the sake of brief description with reference to the drawings, the same or equivalent components may be provided with the same or similar reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

Mobile terminals presented herein may be implemented using a variety of different types of terminals. Examples of such terminals include cellular phones, smart phones, user equipment, laptop computers, digital broadcast terminals, personal digital assistants (PDAs), portable multimedia players (PMPs), navigators, portable computers (PCs), slate PCs, tablet PCs, ultra books, wearable devices (for example, smart watches, smart glasses, head mounted displays (HMDs)), and the like.

By way of non-limiting example only, further description will be made with reference to particular types of mobile terminals. However, such teachings apply equally to other types of terminals, such as those types noted above. In addition, these teachings may also be applied to stationary terminals such as digital TV, desktop computers, and the like. That is, the present invention mainly describes a mobile terminal, which is described as an example of an electronic device including a fixed terminal.

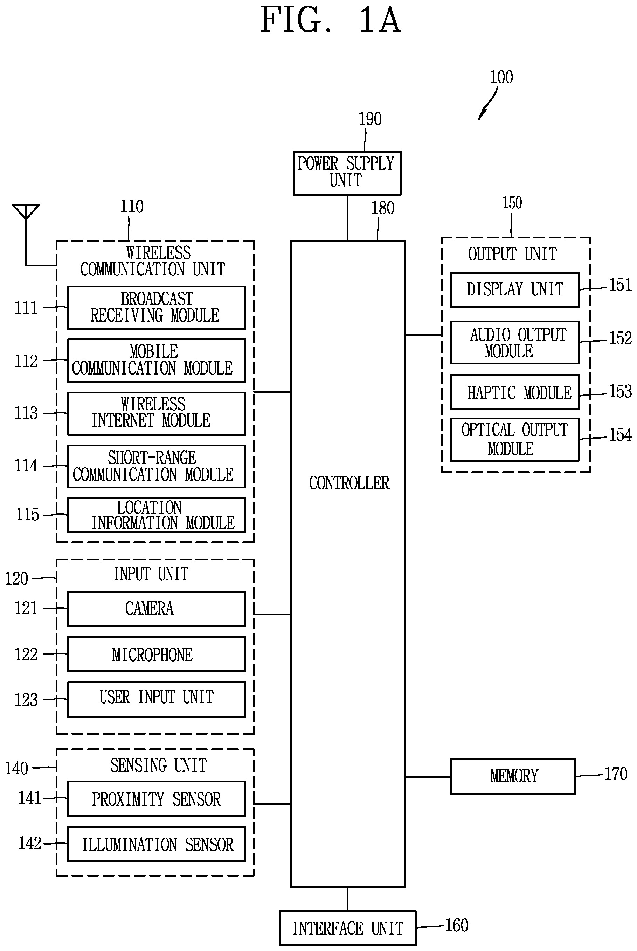

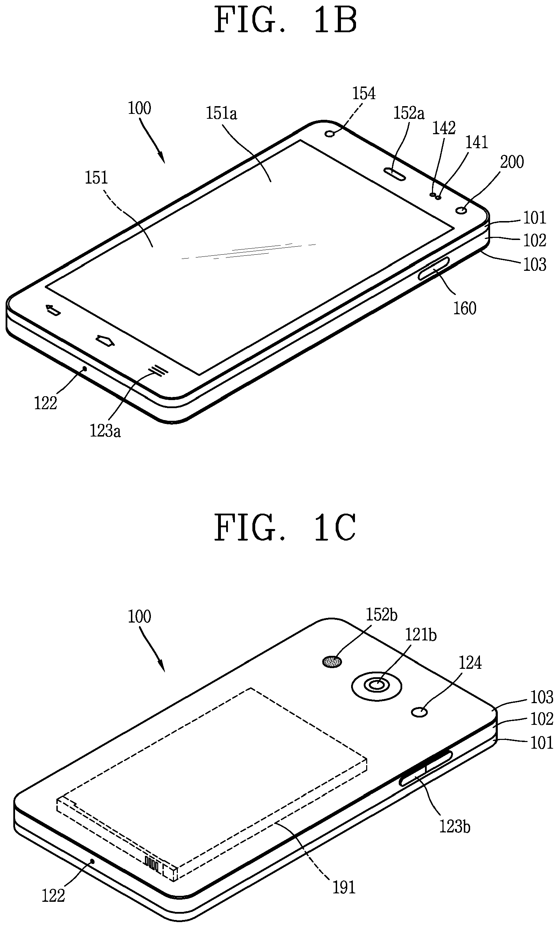

Reference is now made to FIGS. 1A-1C, where FIG. 1A is a block diagram of a mobile terminal in accordance with the present disclosure, and FIGS. 1B and 1C are conceptual views of one example of the mobile terminal, viewed from different directions. The mobile terminal 100 is shown having components such as a wireless communication unit 110, an input unit 120, a sensing unit 140, an output unit 150, an interface unit 160, a memory 170, a controller 180, and a power supply unit 190. Implementing all of the illustrated components is not a requirement, and that greater or fewer components may alternatively be implemented.

The wireless communication unit 110 typically includes one or more modules which permit communications such as wireless communications between the mobile terminal 100 and a wireless communication system, communications between the mobile terminal 100 and another mobile terminal, communications between the mobile terminal 100 and an external server.

Further, the wireless communication unit 110 typically includes one or more modules which connect the mobile terminal 100 to one or more networks. To facilitate such communications, the wireless communication unit 110 includes one or more of a broadcast receiving module 111, a mobile communication module 112, a wireless Internet module 113, a short-range communication module 114, and a location information module 115.

The input unit 120 includes a camera 121 for obtaining images or video, a microphone 122, which is one type of audio input device for inputting an audio signal, and a user input unit 123 (for example, a touch key, a push key, a mechanical key, a soft key, and the like) for allowing a user to input information. Data (for example, audio, video, image, and the like) is obtained by the input unit 120 and may be analyzed and processed by controller 180 according to device parameters, user commands, and combinations thereof.

The sensing unit 140 is typically implemented using one or more sensors configured to sense internal information of the mobile terminal, the surrounding environment of the mobile terminal, user information, and the like. For example, in FIG. 1A, the sensing unit 140 is shown having a proximity sensor 141 and an illumination sensor 142. If desired, the sensing unit 140 may alternatively or additionally include other types of sensors or devices, such as a touch sensor, an acceleration sensor, a magnetic sensor, a G-sensor, a gyroscope sensor, a motion sensor, an RGB sensor, an infrared (IR) sensor, a finger scan sensor, a ultrasonic sensor, an optical sensor (for example, camera 121), a microphone 122, a battery gauge, an environment sensor (for example, a barometer, a hygrometer, a thermometer, a radiation detection sensor, a thermal sensor, and a gas sensor, among others), and a chemical sensor (for example, an electronic nose, a health care sensor, a biometric sensor, and the like), to name a few. The mobile terminal 100 may be configured to utilize information obtained from sensing unit 140, and in particular, information obtained from one or more sensors of the sensing unit 140, and combinations thereof.

The output unit 150 is typically configured to output various types of information, such as audio, video, tactile output, and the like. The output unit 150 is shown having a display unit 151, an audio output module 152, a haptic module 153, and an optical output module 154.

The display unit 151 may have an inter-layered structure or an integrated structure with a touch sensor in order to facilitate a touch screen. The touch screen may provide an output interface between the mobile terminal 100 and a user, as well as function as the user input unit 123 which provides an input interface between the mobile terminal 100 and the user.

The interface unit 160 serves as an interface with various types of external devices that can be coupled to the mobile terminal 100. The interface unit 160, for example, may include any of wired or wireless ports, external power supply ports, wired or wireless data ports, memory card ports, ports for connecting a device having an identification module, audio input/output (I/O) ports, video I/O ports, earphone ports, and the like. In some cases, the mobile terminal 100 may perform assorted control functions associated with a connected external device, in response to the external device being connected to the interface unit 160.

The memory 170 is typically implemented to store data to support various functions or features of the mobile terminal 100. For instance, the memory 170 may be configured to store application programs executed in the mobile terminal 100, data or instructions for operations of the mobile terminal 100, and the like. Some of these application programs may be downloaded from an external server via wireless communication. Other application programs may be installed within the mobile terminal 100 at time of manufacturing or shipping, which is typically the case for basic functions of the mobile terminal 100 (for example, receiving a call, placing a call, receiving a message, sending a message, and the like). It is common for application programs to be stored in the memory 170, installed in the mobile terminal 100, and executed by the controller 180 to perform an operation (or function) for the mobile terminal 100.

The controller 180 typically functions to control overall operation of the mobile terminal 100, in addition to the operations associated with the application programs. The controller 180 can provide or process information or functions appropriate for a user by processing signals, data, information and the like, which are input or output by the various components depicted in FIG.. 1A, or activating application programs stored in the memory 170. As one example, the controller 180 controls some or all of the components illustrated in FIGS. 1A-1C according to the execution of an application program that have been stored in the memory 170.

The power supply unit 190 can be configured to receive external power or provide internal power in order to supply appropriate power required for operating elements and components included in the mobile terminal 100. The power supply unit 190 may include a battery, and the battery may be configured to be embedded in the terminal body, or configured to be detachable from the terminal body.

At least some of the above components may operate in a cooperating manner, so as to implement an operation or a control method of a glass type terminal according to various embodiments to be explained later. The operation or the control method of the glass type terminal may be implemented on the glass type terminal by driving at least one application program stored in the memory 170.

Referring still to FIG. 1A, various components depicted in this figure will now be described in more detail. Regarding the wireless communication unit 110, the broadcast receiving module 111 is typically configured to receive a broadcast signal and/or broadcast associated information from an external broadcast managing entity via a broadcast channel. The broadcast channel may include a satellite channel, a terrestrial channel, or both. In some embodiments, two or more broadcast receiving modules 111 may be utilized to facilitate simultaneously receiving of two or more broadcast channels, or to support switching among broadcast channels.

The mobile communication module 112 can transmit and/or receive wireless signals to and from one or more network entities. Typical examples of a network entity include a base station, an external mobile terminal, a server, and the like. Such network entities form part of a mobile communication network, which is constructed according to technical standards or communication methods for mobile communications (for example, Global System for Mobile Communication (GSM), Code Division Multi Access (CDMA), CDMA2000 (Code Division Multi Access 2000), EV-DO (Enhanced Voice-Data Optimized or Enhanced Voice-Data Only), Wideband CDMA (WCDMA), High Speed Downlink Packet access (HSDPA), HSUPA (High Speed Uplink Packet Access), Long Term Evolution (LTE), LTE-A (Long Term Evolution-Advanced), and the like). Examples of wireless signals transmitted and/or received via the mobile communication module 112 include audio call signals, video (telephony) call signals, or various formats of data to support communication of text and multimedia messages.

The wireless Internet module 113 is configured to facilitate wireless Internet access. This module may be internally or externally coupled to the mobile terminal 100. The wireless Internet module 113 may transmit and/or receive wireless signals via communication networks according to wireless Internet technologies. Examples of such wireless Internet access include Wireless LAN (WLAN), Wireless Fidelity (Wi-Fi), Wi-Fi Direct, Digital Living Network Alliance (DLNA), Wireless Broadband (WiBro), Worldwide Interoperability for Microwave Access (WiMAX), High Speed Downlink Packet Access (HSDPA), HSUPA (High Speed Uplink Packet Access), Long Term Evolution (LTE), LTE-A (Long Term Evolution-Advanced), and the like. The wireless Internet module 113 may transmit/receive data according to one or more of such wireless Internet technologies, and other Internet technologies as well.

In some embodiments, when the wireless Internet access is implemented according to, for example, WiBro, HSDPA,HSUPA, GSM, CDMA, WCDMA, LTE, LTE-A and the like, as part of a mobile communication network, the wireless Internet module 113 performs such wireless Internet access. As such, the Internet module 113 may cooperate with, or function as, the mobile communication module 112.

The short-range communication module 114 is configured to facilitate short-range communications. Suitable technologies for implementing such short-range communications include BLUETOOTHTM, Radio Frequency IDentification (RFID), Infrared Data Association (IrDA), Ultra-WideBand (UWB), ZigBee, Near Field Communication (NFC), Wireless-Fidelity (Wi-Fi), Wi-Fi Direct, Wireless USB (Wireless Universal Serial Bus), and the like. The short-range communication module 114 in general supports wireless communications between the mobile terminal 100 and a wireless communication system, communications between the mobile terminal 100 and another mobile terminal 100, or communications between the mobile terminal and a network where another mobile terminal 100 (or an external server) is located, via wireless area networks. One example of the wireless area networks is a wireless personal area networks.

In some embodiments, another mobile terminal (which may be configured similarly to mobile terminal 100) may be a wearable device, for example, a smart watch, a smart glass or a head mounted display (HMD), which can exchange data with the mobile terminal 100 (or otherwise cooperate with the mobile terminal 100). The short-range communication module 114 may sense or recognize the wearable device, and permit communication between the wearable device and the mobile terminal 100. In addition, when the sensed wearable device is a device which is authenticated to communicate with the mobile terminal 100, the controller 180, for example, may cause transmission of data processed in the mobile terminal 100 to the wearable device via the short-range communication module 114. Hence, a user of the wearable device may use the data processed in the mobile terminal 100 on the wearable device. For example, when a call is received in the mobile terminal 100, the user may answer the call using the wearable device. Also, when a message is received in the mobile terminal 100, the user can check the received message using the wearable device.

The location information module 115 is generally configured to detect, calculate, derive or otherwise identify a position of the mobile terminal. As an example, the location information module 115 includes a Global Position System (GPS) module, a Wi-Fi module, or both. If desired, the location information module 115 may alternatively or additionally function with any of the other modules of the wireless communication unit 110 to obtain data related to the position of the mobile terminal.

As one example, when the mobile terminal uses a GPS module, a position of the mobile terminal may be acquired using a signal sent from a GPS satellite. As another example, when the mobile terminal uses the Wi-Fi module, a position of the mobile terminal can be acquired based on information related to a wireless access point (AP) which transmits or receives a wireless signal to or from the Wi-Fi module.

The input unit 120 may be configured to permit various types of input to the mobile terminal 120. Examples of such input include audio, image, video, data, and user input. Image and video input is often obtained using one or more cameras 121. Such cameras 121 may process image frames of still pictures or video obtained by image sensors in a video or image capture mode. The processed image frames can be displayed on the display unit 151 or stored in memory 170. In some cases, the cameras 121 may be arranged in a matrix configuration to permit a plurality of images having various angles or focal points to be input to the mobile terminal 100. As another example, the cameras 121 may be located in a stereoscopic arrangement to acquire left and right images for implementing a stereoscopic image.

The microphone 122 is generally implemented to permit audio input to the mobile terminal 100. The audio input can be processed in various manners according to a function being executed in the mobile terminal 100. If desired, the microphone 122 may include assorted noise removing algorithms to remove unwanted noise generated in the course of receiving the external audio.

The user input unit 123 is a component that permits input by a user. Such user input may enable the controller 180 to control operation of the mobile terminal 100. The user input unit 123 may include one or more of a mechanical input element (for example, a key, a button located on a front and/or rear surface or a side surface of the mobile terminal 100, a dome switch, a jog wheel, a jog switch, and the like), or a touch-sensitive input, among others. As one example, the touch-sensitive input may be a virtual key or a soft key, which is displayed on a touch screen through software processing, or a touch key which is located on the mobile terminal at a location that is other than the touch screen. Further, the virtual key or the visual key may be displayed on the touch screen in various shapes, for example, graphic, text, icon, video, or a combination thereof.

The sensing unit 140 is generally configured to sense one or more of internal information of the mobile terminal, surrounding environment information of the mobile terminal, user information, or the like. The controller 180 generally cooperates with the sending unit 140 to control operation of the mobile terminal 100 or execute data processing, a function or an operation associated with an application program installed in the mobile terminal based on the sensing provided by the sensing unit 140. The sensing unit 140 may be implemented using any of a variety of sensors, some of which will now be described in more detail.

The proximity sensor 141 may include a sensor to sense presence or absence of an object approaching a surface, or an object located near a surface, by using an electromagnetic field, infrared rays, or the like without a mechanical contact. The proximity sensor 141 may be arranged at an inner region of the mobile terminal covered by the touch screen, or near the touch screen.

The proximity sensor 141, for example, may include any of a transmissive type photoelectric sensor, a direct reflective type photoelectric sensor, a mirror reflective type photoelectric sensor, a high-frequency oscillation proximity sensor, a capacitance type proximity sensor, a magnetic type proximity sensor, an infrared rays proximity sensor, and the like. When the touch screen is implemented as a capacitance type, the proximity sensor 141 can sense proximity of a pointer relative to the touch screen by changes of an electromagnetic field, which is responsive to an approach of an object with conductivity. In this instance, the touch screen (touch sensor) may also be categorized as a proximity sensor.

The term "proximity touch" will often be referred to herein to denote the scenario in which a pointer is positioned to be proximate to the touch screen without contacting the touch screen. The term "contact touch" will often be referred to herein to denote the scenario in which a pointer makes physical contact with the touch screen. For the position corresponding to the proximity touch of the pointer relative to the touch screen, such position will correspond to a position where the pointer is perpendicular to the touch screen. The proximity sensor 141 may sense proximity touch, and proximity touch patterns (for example, distance, direction, speed, time, position, moving status, and the like). In general, controller 180 processes data corresponding to proximity touches and proximity touch patterns sensed by the proximity sensor 141, and cause output of visual information on the touch screen. In addition, the controller 180 can control the mobile terminal 100 to execute different operations or process different data according to whether a touch with respect to a point on the touch screen is either a proximity touch or a contact touch.

A touch sensor can sense a touch applied to the touch screen, such as display unit 151, using any of a variety of touch methods. Examples of such touch methods include a resistive type, a capacitive type, an infrared type, and a magnetic field type, among others. As one example, the touch sensor may be configured to convert changes of pressure applied to a specific part of the display unit 151, or convert capacitance occurring at a specific part of the display unit 151, into electric input signals. The touch sensor may also be configured to sense not only a touched position and a touched area, but also touch pressure and/or touch capacitance. A touch object is generally used to apply a touch input to the touch sensor. Examples of typical touch objects include a finger, a touch pen, a stylus pen, a pointer, or the like.

When a touch input is sensed by a touch sensor, corresponding signals may be transmitted to a touch controller. The touch controller may process the received signals, and then transmit corresponding data to the controller 180. Accordingly, the controller 180 can sense which region of the display unit 151 has been touched. Here, the touch controller may be a component separate from the controller 180, the controller 180, and combinations thereof.

In some embodiments, the controller 180 can execute the same or different controls according to a type of touch object that touches the touch screen or a touch key provided in addition to the touch screen. Whether to execute the same or different control according to the object which provides a touch input may be decided based on a current operating state of the mobile terminal 100 or a currently executed application program, for example.

The touch sensor and the proximity sensor may be implemented individually, or in combination, to sense various types of touches. Such touches includes a short (or tap) touch, a long touch, a multi-touch, a drag touch, a flick touch, a pinch-in touch, a pinch-out touch, a swipe touch, a hovering touch, and the like.

If desired, an ultrasonic sensor may be implemented to recognize position information relating to a touch object using ultrasonic waves. The controller 180, for example, can calculate a position of a wave generation source based on information sensed by an illumination sensor and a plurality of ultrasonic sensors. Since light is much faster than ultrasonic waves, the time for which the light reaches the optical sensor is much shorter than the time for which the ultrasonic wave reaches the ultrasonic sensor. The position of the wave generation source can be calculated using this fact. For instance, the position of the wave generation source can be calculated using the time difference from the time that the ultrasonic wave reaches the sensor based on the light as a reference signal.

The camera 121 typically includes at least one a camera sensor (CCD, CMOS etc.), a photo sensor (or image sensors), and a laser sensor. Implementing the camera 121 with a laser sensor may allow detection of a touch of a physical object with respect to a 3D stereoscopic image. The photo sensor may be laminated on, or overlapped with, the display device. The photo sensor may be configured to scan movement of the physical object in proximity to the touch screen. In more detail, the photo sensor may include photo diodes and transistors at rows and columns to scan content received at the photo sensor using an electrical signal which changes according to the quantity of applied light. Namely, the photo sensor may calculate the coordinates of the physical object according to variation of light to thus obtain position information of the physical object.

The display unit 151 is generally configured to output information processed in the mobile terminal 100. For example, the display unit 151 can display execution screen information of an application program executing at the mobile terminal 100 or user interface (UI) and graphic user interface (GUI) information in response to the execution screen information. In some embodiments, the display unit 151 may be implemented as a stereoscopic display unit for displaying stereoscopic images. A typical stereoscopic display unit may employ a stereoscopic display scheme such as a stereoscopic scheme (a glass scheme), an auto-stereoscopic scheme (glassless scheme), a projection scheme (holographic scheme), or the like.

The audio output module 152 is generally configured to output audio data. Such audio data may be obtained from any of a number of different sources, such that the audio data may be received from the wireless communication unit 110 or may have been stored in the memory 170. The audio data may be output during modes such as a signal reception mode, a call mode, a record mode, a voice recognition mode, a broadcast reception mode, and the like. The audio output module 152 can provide audible output related to a particular function (e.g., a call signal reception sound, a message reception sound, etc.) performed by the mobile terminal 100. The audio output module 152 may also be implemented as a receiver, a speaker, a buzzer, or the like.

A haptic module 153 can be configured to generate various tactile effects that a user feels, perceive, or otherwise experience. A typical example of a tactile effect generated by the haptic module 153 is vibration. The strength, pattern and the like of the vibration generated by the haptic module 153 can be controlled by user selection or setting by the controller. For example, the haptic module 153 may output different vibrations in a combining manner or a sequential manner.

Besides vibration, the haptic module 153 can generate various other tactile effects, including an effect by stimulation such as a pin arrangement vertically moving to contact skin, a spray force or suction force of air through a jet orifice or a suction opening, a touch to the skin, a contact of an electrode, electrostatic force, an effect by reproducing the sense of cold and warmth using an element that can absorb or generate heat, and the like.

The haptic module 153 can also be implemented to allow the user to feel a tactile effect through a muscle sensation such as the user's fingers or arm, as well as transferring the tactile effect through direct contact. Two or more haptic modules 153 may be provided according to the particular configuration of the mobile terminal 100.

An optical output module 154 can output a signal for indicating an event generation using light of a light source. Examples of events generated in the mobile terminal 100 may include message reception, call signal reception, a missed call, an alarm, a schedule notice, an email reception, information reception through an application, and the like.

A signal output by the optical output module 154 may be implemented so the mobile terminal emits monochromatic light or light with a plurality of colors. The signal output may be terminated as the mobile terminal senses that a user has checked the generated event, for example.

The interface unit 160 serves as an interface for external devices to be connected with the mobile terminal 100. For example, the interface unit 160 can receive data transmitted from an external device, receive power to transfer to elements and components within the mobile terminal 100, or transmit internal data of the mobile terminal 100 to such external device. The interface unit 160 may include wired or wireless headset ports, external power supply ports, wired or wireless data ports, memory card ports, ports for connecting a device having an identification module, audio input/output (I/O) ports, video I/O ports, earphone ports, or the like.

The identification module may be a chip that stores various information for authenticating authority of using the mobile terminal 100 and may include a user identity module (UIM), a subscriber identity module (SIM), a universal subscriber identity module (USIM), and the like. In addition, the device having the identification module (also referred to herein as an "identifying device") may take the form of a smart card. Accordingly, the identifying device can be connected with the terminal 100 via the interface unit 160.

When the mobile terminal 100 is connected with an external cradle, the interface unit 160 can serve as a passage to allow power from the cradle to be supplied to the mobile terminal 100 or may serve as a passage to allow various command signals input by the user from the cradle to be transferred to the mobile terminal there through. Various command signals or power input from the cradle may operate as signals for recognizing that the mobile terminal is properly mounted on the cradle.

The memory 170 can store programs to support operations of the controller 180 and store input/output data (for example, phonebook, messages, still images, videos, etc.). The memory 170 may store data related to various patterns of vibrations and audio which are output in response to touch inputs on the touch screen.

The memory 170 may include one or more types of storage mediums including a Flash memory, a hard disk, a solid state disk, a silicon disk, a multimedia card micro type, a card-type memory (e.g., SD or DX memory, etc.), a Random Access Memory (RAM), a Static Random Access Memory (SRAM), a Read-Only Memory (ROM), an Electrically Erasable Programmable Read-Only Memory (EEPROM), a Programmable Read-Only memory (PROM), a magnetic memory, a magnetic disk, an optical disk, and the like. The mobile terminal 100 may also be operated in relation to a network storage device that performs the storage function of the memory 170 over a network, such as the Internet.

The controller 180 can typically control the general operations of the mobile terminal 100. For example, the controller 180 can set or release a lock state for restricting a user from inputting a control command with respect to applications when a status of the mobile terminal meets a preset condition.

The controller 180 can also perform the controlling and processing associated with voice calls, data communications, video calls, and the like, or perform pattern recognition processing to recognize a handwriting input or a picture drawing input performed on the touch screen as characters or images, respectively. In addition, the controller 180 can control one or a combination of those components in order to implement various exemplary embodiments disclosed herein.

The power supply unit 190 receives external power or provide internal power and supply the appropriate power required for operating respective elements and components included in the mobile terminal 100. The power supply unit 190 may include a battery, which is typically rechargeable or be detachably coupled to the terminal body for charging.

The power supply unit 190 may include a connection port. The connection port may be configured as one example of the interface unit 160 to which an external charger for supplying power to recharge the battery is electrically connected. As another example, the power supply unit 190 may be configured to recharge the battery in a wireless manner without use of the connection port. In this example, the power supply unit 190 can receive power, transferred from an external wireless power transmitter, using at least one of an inductive coupling method which is based on magnetic induction or a magnetic resonance coupling method which is based on electromagnetic resonance. Various embodiments described herein may be implemented in a computer-readable medium, a machine-readable medium, or similar medium using, for example, software, hardware, or any combination thereof.

Referring now to FIGS. 1B and 1C, the mobile terminal 100 is described with reference to a bar-type terminal body. However, the mobile terminal 100 may alternatively be implemented in any of a variety of different configurations. Examples of such configurations include watch-type, clip-type, glasses-type, or as a folder-type, flip-type, slide-type, swing-type, and swivel-type in which two and more bodies are combined with each other in a relatively movable manner, and combinations thereof. Discussion herein will often relate to a particular type of mobile terminal (for example, bar-type, watch-type, glasses-type, and the like). However, such teachings with regard to a particular type of mobile terminal will generally apply to other types of mobile terminals as well.

The mobile terminal 100 will generally include a case (for example, frame, housing, cover, and the like) forming the appearance of the terminal. In this embodiment, the case is formed using a front case 101 and a rear case 102. Various electronic components are incorporated into a space formed between the front case 101 and the rear case 102. At least one middle case may be additionally positioned between the front case 101 and the rear case 102.

The display unit 151 is shown located on the front side of the terminal body to output information. As illustrated, a window 151a of the display unit 151 may be mounted to the front case 101 to form the front surface of the terminal body together with the front case 101. In some embodiments, electronic components may also be mounted to the rear case 102. Examples of such electronic components include a detachable battery 191, an identification module, a memory card, and the like. Rear cover 103 is shown covering the electronic components, and this cover may be detachably coupled to the rear case 102. Therefore, when the rear cover 103 is detached from the rear case 102, the electronic components mounted to the rear case 102 are externally exposed.

As illustrated, when the rear cover 103 is coupled to the rear case 102, a side surface of the rear case 102 is partially exposed. In some cases, upon the coupling, the rear case 102 may also be completely shielded by the rear cover 103. In some embodiments, the rear cover 103 may include an opening for externally exposing a camera 121b or an audio output module 152b.

The cases 101, 102, 103 may be formed by injection-molding synthetic resin or may be formed of a metal, for example, stainless steel (STS), aluminum (Al), titanium (Ti), or the like. As an alternative to the example in which the plurality of cases form an inner space for accommodating components, the mobile terminal 100 may be configured such that one case forms the inner space. In this example, a mobile terminal 100 having a uni-body is formed so synthetic resin or metal extends from a side surface to a rear surface.

If desired, the mobile terminal 100 may include a waterproofing unit for preventing introduction of water into the terminal body. For example, the waterproofing unit may include a waterproofing member which is located between the window 151a and the front case 101, between the front case 101 and the rear case 102, or between the rear case 102 and the rear cover 103, to hermetically seal an inner space when those cases are coupled.

The mobile terminal 100 may include the display unit 151, the first audio output module 152a, the second audio output module 152b, the proximity sensor 141, the illumination sensor 142, the optical output module 154, the first camera 121a, the second camera 121b, the first manipulation unit 123a, the second manipulation unit 123b, the microphone 122, the interface unit 160, etc.

Hereinafter, the mobile terminal 100 will be explained with reference to FIGS. 1B and 1C. The display unit 151, the first audio output module 152a, the proximity sensor 141, the illumination sensor 142, the optical output module 154, the first camera 121a and the first manipulation unit 123a are arranged on the front surface of the terminal body. The second manipulation unit 123b, the microphone 122 and the interface unit 160 are arranged on the side surfaces of the terminal body. The second audio output module 152b and the second camera 121b are arranged on the rear surface of the terminal body.

However, alternative arrangements are possible and within the teachings of the instant disclosure. Some components may be omitted or rearranged. For example, the first manipulation unit 123a may be located on another surface of the terminal body, and the second audio output module 152b may be located on the side surface of the terminal body.

The display unit 151 outputs information processed in the mobile terminal 100. For example, the display unit 151 may display information on an execution screen of an application program driven in the mobile terminal 100, or a User Interface (UI) or a Graphic User Interface (GUI) associated with such execution screen information. The display unit 151 may be implemented using one or more suitable display devices. Examples of such suitable display devices include a liquid crystal display (LCD), a thin film transistor-liquid crystal display (TFT-LCD), an organic light emitting diode (OLED), a flexible display, a 3-dimensional (3D) display, an e-ink display, and combinations thereof.

The display unit 151 may be implemented using two display devices, which can implement the same or different display technology. For instance, a plurality of the display units 151 may be arranged on one side, either spaced apart from each other, or these devices may be integrated, or these devices may be arranged on different surfaces. The display unit 151 may also include a touch sensor which senses a touch input received at the display unit. When a touch is input to the display unit 151, the touch sensor may be configured to sense this touch and the controller 180, for example, may generate a control command or other signal corresponding to the touch. The content which is input in the touching manner may be a text or numerical value, or a menu item which can be indicated or designated in various modes.

The touch sensor may be configured in a form of a film having a touch pattern, disposed between the window 151a and a display on a rear surface of the window 151a, or a metal wire which is patterned directly on the rear surface of the window 151a. Alternatively, the touch sensor may be integrally formed with the display. For example, the touch sensor may be disposed on a substrate of the display or within the display.

The display unit 151 can also form a touch screen together with the touch sensor. Here, the touch screen can serve as the user input unit 123 (see FIG. 1A). Therefore, the touch screen may replace at least some of the functions of the first manipulation unit 123a.

The first audio output unit 152a may be implemented as a receiver for transmitting a call sound to a user's ears, and the second audio output unit 152b may be implemented as a loud speaker for outputting each type of alarm sounds or a play sound of multimedia. It may be configured such that the sounds generated from the first audio output module 152a are released along an assembly gap between the structural bodies (e.g., between the window 151a and the front case 101). In this instance, a hole independently formed to output audio sounds may not be seen or hidden in terms of appearance, thereby further simplifying the appearance of the mobile terminal 100.

The optical output module 154 can output a signal for indicating an event generation using light of a light source. Examples of events generated in the mobile terminal 100 may include message reception, call signal reception, a missed call, an alarm, a schedule notice, an email reception, information reception through an application, and the like. A signal output by the optical output module 154 may be implemented so the mobile terminal emits monochromatic light or light with a plurality of colors. The signal output may be terminated as the mobile terminal senses that a user has checked the generated event, for example.

The first camera 121a processes image data of still pictures or video acquired by an image capture device in a video capturing mode or an image capturing mode. The processed image frames may be displayed on the display unit 151, or may be stored in the memory 170.

The first and second manipulation units 123a and 123b are examples of the user input unit 123, which may be manipulated by a user to provide input to the mobile terminal 100. The first and second manipulation units 123a and 123b may also be commonly referred to as a manipulating portion, and may employ any tactile method that allows the user to perform manipulation such as touch, push, scroll, or the like. The first and second manipulation units 123a and 123b may be implemented in a user's non-tactile manner, e.g., by a proximity touch, a hovering touch, etc.

FIG. 1B illustrates the first manipulation unit 123a as a touch key, but possible alternatives include a mechanical key, a push key, a touch key, and combinations thereof. Input received at the first and second manipulation units 123a and 123b may be used in various ways. For example, the first manipulation unit 123a may be used by the user to provide an input to a menu, home key, cancel, search, or the like, and the second manipulation unit 123b may be used by the user to provide an input to control a volume level being output from the first or second audio output modules 152a or 152b, to switch to a touch recognition mode of the display unit 151, or the like.

As another example of the user input unit 123, a rear input unit may be located on the rear surface of the terminal body. The rear input unit can be manipulated by a user to provide input to the mobile terminal 100. The input may be used in a variety of different ways. For example, the rear input unit may be used by the user to provide an input for power on/off, start, end, scroll, control volume level being output from the first or second audio output modules 152a or 152b, switch to a touch recognition mode of the display unit 151, and the like. The rear input unit may be configured to permit touch input, a push input, or combinations thereof.

The rear input unit may be located to overlap the display unit 151 of the front side in a thickness direction of the terminal body. As one example, the rear input unit may be located on an upper end portion of the rear side of the terminal body such that a user can easily manipulate it using a forefinger when the user grabs the terminal body with one hand. Alternatively, the rear input unit can be positioned at most any location of the rear side of the terminal body.

Embodiments that include the rear input unit may implement some or all of the functionality of the first manipulation unit 123a in the rear input unit. As such, in situations where the first manipulation unit 123a is omitted from the front side, the display unit 151 can have a larger screen. As a further alternative, the mobile terminal 100 may include a finger scan sensor which scans a user's fingerprint. The controller 180 can then use fingerprint information sensed by the finger scan sensor as part of an authentication procedure. The finger scan sensor may also be installed in the display unit 151 or implemented in the user input unit 123.

The microphone 122 is shown located at an end of the mobile terminal 100, but other locations are possible. If desired, multiple microphones may be implemented, with such an arrangement permitting the receiving of stereo sounds.

The interface unit 160 may serve as a path allowing the mobile terminal 100 to interface with external devices. For example, the interface unit 160 may include one or more of a connection terminal for connecting to another device (for example, an earphone, an external speaker, or the like), a port for near field communication (for example, an Infrared Data Association (IrDA) port, a Bluetooth port, a wireless LAN port, and the like), or a power supply terminal for supplying power to the mobile terminal 100. The interface unit 160 may be implemented in the form of a socket for accommodating an external card, such as Subscriber Identification Module (SIM), User Identity Module (UIM), or a memory card for information storage.

The second camera 121b is shown located at the rear side of the terminal body and includes an image capturing direction that is substantially opposite to the image capturing direction of the first camera unit 121a. If desired, second camera 121a may alternatively be located at other locations, or made to be moveable, in order to have a different image capturing direction from that which is shown.

The second camera 121b can include a plurality of lenses arranged along at least one line. The plurality of lenses may also be arranged in a matrix configuration. The cameras may be referred to as an "array camera." When the second camera 121b is implemented as an array camera, images may be captured in various manners using the plurality of lenses and images with better qualities.

As shown in FIG. 1C, a flash 124 is shown adjacent to the second camera 121b. When an image of a subject is captured with the camera 121b, the flash 124 may illuminate the subject. As shown in FIG. 1C, the second audio output module 152b can be located on the terminal body. The second audio output module 152b may implement stereophonic sound functions in conjunction with the first audio output module 152a, and may be also used for implementing a speaker phone mode for call communication.

At least one antenna for wireless communication may be located on the terminal body. The antenna may be installed in the terminal body or formed by the case. For example, an antenna which configures a part of the broadcast receiving module 111 (See FIG. 1A) may be retractable into the terminal body. Alternatively, an antenna may be formed using a film attached to an inner surface of the rear cover 103, or a case that includes a conductive material.

A power supply unit 190 for supplying power to the mobile terminal 100 may include a battery 191, which is mounted in the terminal body or detachably coupled to an outside of the terminal body. The battery 191 may receive power via a power source cable connected to the interface unit 160. Also, the battery 191 can be recharged in a wireless manner using a wireless charger. Wireless charging may be implemented by magnetic induction or electromagnetic resonance.

The rear cover 103 is shown coupled to the rear case 102 for shielding the battery 191, to prevent separation of the battery 191, and to protect the battery 191 from an external impact or from foreign material. When the battery 191 is detachable from the terminal body, the rear case 103 may be detachably coupled to the rear case 102.

An accessory for protecting an appearance or assisting or extending the functions of the mobile terminal 100 can also be provided on the mobile terminal 100. As one example of an accessory, a cover or pouch for covering or accommodating at least one surface of the mobile terminal 100 may be provided. The cover or pouch may cooperate with the display unit 151 to extend the function of the mobile terminal 100. Another example of the accessory is a touch pen for assisting or extending a touch input to a touch screen.

Referring to FIG. 1A, a main body of a mobile terminal 100 includes a bezel portion which surrounds an edge of the display unit 151 and forms an edge of the mobile terminal 100. No image is output on the bezel portion, and various electronic components and circuits are arranged inside the bezel portion. A camera device 200 according to the present disclosure is disposed below the bezel portion.

A camera device according to an embodiment of the present disclosure has a structure in which the camera device is reduced in width so as to be disposed in the bezel portion having a predetermined width. As the width of the camera device is reduced, a space around the camera device is minimized to reduce a thickness of the bezel portion. Hereinafter, the camera device 200 having the structure with a reduced width will be described in more detail.

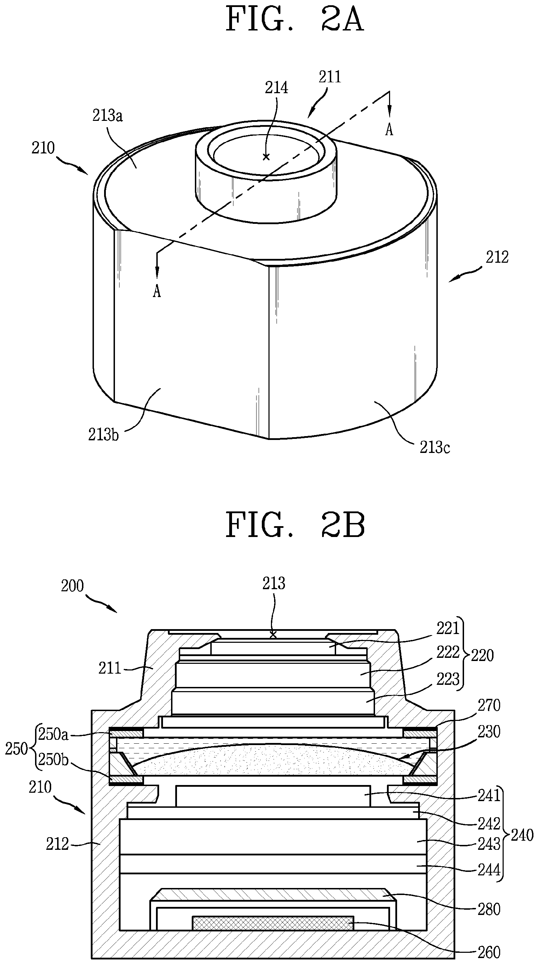

In particular, FIG. 2A is a view of the camera device viewed from one direction, and FIG. 2B is a cross-sectional view of the camera device of FIG. 2A, taken along line A-A.

Referring to FIGS. 2A and 2B, the camera device 200 according to an embodiment of the present disclosure may include a lens cover 210, lens assemblies 220, 230 and 240, an image sensor 260, a masking portion 270, and an infrared cut filter 280. However, only some of the lens cover 210, the lens assemblies 220, 230 and 240, the image sensor 260, the masking portion 270 and the IR cut filter 280 may be combined to configure the camera device. For example, the camera device may not include the masking portion and the infrared cut filter, if necessary.

Referring to FIG. 2A, the lens cover 210 forms an appearance of the camera device 200 and forms an internal space for accommodating the lens assemblies 220, 230, and 240. An outer surface of the lens cover 210 includes a pair of planes 213b opposing each other on the side surface. The pair of planes 213b are formed flat and connected by a pair of curved surfaces 213c opposing each other.

That is, the outer surface of the lens cover 210 has a cylindrical shape, and a portion of the lens cover 210 is cut. However, the present disclosure is not limited thereto, and the outer surface of the lens cover may have a rectangular shape. A first portion 211, which will be described later, may protrude from an upper end surface 213a of the lens cover 210.

In the lens cover 210, the lens assemblies 220, 230, and 240 including a plurality of lenses are disposed in an internal space. The lens assemblies 220, 230, and 240 include a plurality of lenses having different diameters and are stacked in one direction in the internal space of the lens cover 210. In addition, the plurality of lenses may be formed to have different diameters, respectively. An inner circumferential surface of the lens cover 210 is formed to have different diameters so that the plurality of lenses having different diameters may be fitted, respectively. That is, the inner circumferential surface of the lens cover 210 may be stepped.

The lens assemblies 220, 230, and 240 including the plurality of lenses may include a first lens unit 220, a liquid lens unit 230, and a second lens unit 240, as described later. The lens cover 210 may be divided into a first portion 211 in which the first lens unit 220 is disposed and a second portion 212 in which the liquid lens unit 230, the second lens unit 240, and the image sensor 260 are disposed. 212. The first portion 211 may protrude from an upper end surface 213a of the lens cover 210 and may have a cylindrical shape. Also, a diameter of the first portion 211 may be smaller than a minimum diameter of the second portion 212.

In addition, the first portion 211 and the second portion 212 may be integrally formed. Generally, a lens assembly of the camera device is coupled as a plurality of holders in which a lens is installed are stacked in one direction. In the camera device 200 according to an embodiment of the present disclosure, the lens cover 210 is integrally formed and each lens may be fitted therein. According to such a structure, a process of coupling the lens holders may be omitted, simplifying the process and reducing a possibility of introduction of a foreign material.

The lens cover 210 has an opening hole 214 through which light passes toward the front side. Specifically, the opening hole 214 is formed at the center of a front surface of the first portion 211. Light incident through the opening hole 214 sequentially passes through the lens assemblies 220, 230, and 240 to form an image on the image sensor.

Hereinafter, the lens assemblies 220, 230, and 240 and the image sensor 260 will be described. Referring to FIG. 2B, the lens assemblies 220, 230, and 240 may include a first lens unit 220, a liquid lens unit 230, and the second lens unit 240. The lens assemblies 220, 230 and 240 are arranged in order of the first lens unit 220, the liquid lens unit 230, and the second lens unit 240 in the internal space of the lens cover 210.

The first lens unit 220 is configured to concentrate light incident from the front side and may include at least one lens, and two or more lenses 221, 222, and 223 may be aligned with respect to a central axis to form an optical system. The second lens unit 240 is configured to form an image on the image sensor using light passing through the liquid lens unit 230. Also, the second lens unit 240 may include at least one lens, and two or more lenses 241, 242, 243, and 244 may be aligned with respect to the central axis to form an optical system.

The first lens unit 220 and the second lens unit 240 together with the liquid lens unit 230 to be described later can form an image on the image sensor 260 using light incident from the outside. The image sensor 260 is disposed behind the second lens unit 240 and forms an image using light which has sequentially passed through the first lens unit 220, the liquid lens unit 230, and the second lens unit 240.

The image sensor 260 is formed such that horizontal and vertical lengths have a specific ratio. The specific ratio may be 4: 3 or 16: 9. A length of the image sensor in a first direction d1 and a length of the image sensor in a second direction d2 perpendicular to the first direction d1 are different. For example, the length of the image sensor 260 in the first direction d1 may be longer than the length of the image sensor 260 in the second direction d2.

In addition, the entire area of the image sensor 260 overlaps the lens assemblies 220, 230, and 240. That is, the edge of the image sensor 260 may be smaller than a minimum diameter of the lens assemblies 220, 230, and 240. Further, since a tilt angle of incident light differs according to distances, the lens assemblies 220, 230, and 240 may adjust a focal length. In the camera device 200 according to the present disclosure, the focal length may be adjusted by the liquid lens unit 230.

Hereinafter, the liquid lens unit 230 will be described in detail. Referring to FIG. 2B, the liquid lens unit 230 is disposed between the first lens unit 220 and the second lens unit 240. However, the present disclosure is not limited thereto and any one of the first lens unit 220 and the second lens unit 240 may be omitted and the liquid lens unit 230 may be disposed on the front or rear side of the first lens unit 220 and the second lens unit 240. In addition, the liquid lens unit 230 may be supported by a support portion protruding from an inner circumferential surface of the lens cover 210 in the circumferential direction.

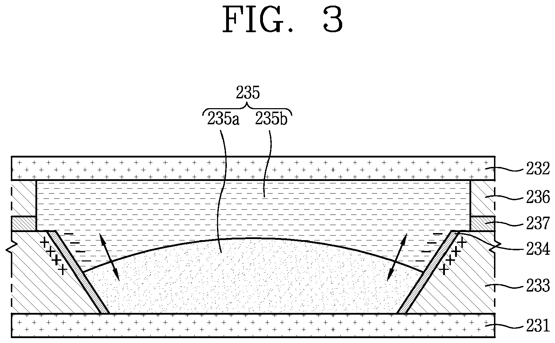

FIG. 3 is a conceptual view illustrating a liquid lens. Hereinafter, a structure of the liquid lens unit 230 will be described in detail with reference to the drawings. The liquid lens unit 230 may include a bottom plate 231 and a top plate 232. In more detail, the bottom plate 231 and the top plate 232 are spaced apart from each other in a thickness direction of the liquid lens unit to form a space filled with the liquid 235 serving as a lens.

In addition, the bottom plate 231 and the top plate 232 may be formed of a transparent member allowing light to be transmitted therethrough. For example, the bottom plate 231 and the top plate 232 may be formed of a glass material. In the present embodiment, when the bottom plate 231 and the top plate 232 are flat plates is exemplified, but the present disclosure is not limited thereto. For example, at least one of the bottom plate 231 and the top plate 232 may be curved in an outer surface or an inner surface thereof or may be a member formed of a flexible material so as to be changed in shape.

The liquid lens unit 230 may include a chamber 233. The chamber 233 is formed on the bottom plate 231. Also, the chamber 233 has a hollow therein, and the hollow is formed to have a diameter increased upwards. That is, the hollow may be formed to be sloped upwards.

Spacers 236 and 237 are disposed above the chamber 233 and include a conductive portion 236 formed of a metal and an insulating portion 237. The insulating portion 237 is disposed between the conductive portion 236 and the chamber 233.

Further, the top plate 232 is disposed above the spacers 236 and 237. Thus, an accommodation space in which a liquid 235 is accommodated can be a space confined by the bottom plate 231, the chamber 233, the spacers 236 and 237 and the top plate 232 in the liquid lens unit 230. The liquid 235 may include a conductive liquid 235b and a non-conductive liquid 235a together. The conductive liquid 235b and the non-conductive liquid 235a may form a boundary without being mixed with each other. For example, the conductive liquid 235b may be water, and the non-conductive liquid 235a may be oil.

An electrode 234 may be formed on an inner circumferential surface of the chamber 233. In particular, the electrode 234 is disposed so as to cover the inner circumferential surface of the chamber. The electrode 234 adjusts a surface tension of the conductive liquid 235b according to an electrical signal, e.g., a driving voltage, applied to the electrode 234.

As the surface tension of the conductive liquid is changed, an interface between the conductive liquid and the non-conductive liquid is deformed, so that a focal length of the liquid lens unit can be adjusted. According to the focal length control of the liquid lens unit can, the camera device including the liquid lens unit 300 may perform auto-focusing, optical image stabilization, and the like.

In addition, the electrical signal, i.e., the driving voltage, is transmitted by a flexible printed circuit board (FPCB) 250 (FIG. 2B). According to the present disclosure, the FPCB 250 is formed to overlap the liquid lens unit 230 in the thickness direction.

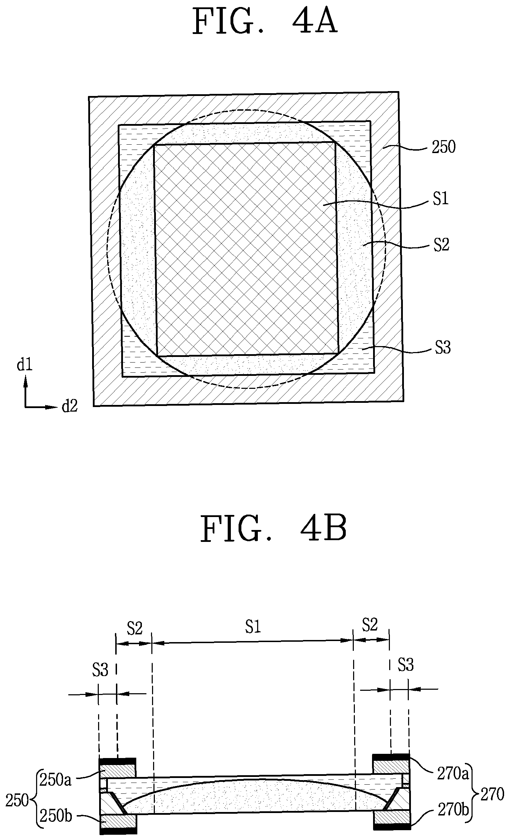

Next, FIG. 4A is a plan view illustrating a liquid lens unit in which an FPCB of the present disclosure is disposed, and FIG. 4B is a side view of the liquid lens unit in which the FPCB illustrated in FIG. 4 is disposed. Referring to the drawings, the liquid lens unit 230 includes lens regions S1 and S2 and a body region S3. The lens regions S1 and S2, corresponding to the liquid portion, through which light passing through the first lens unit 220 is transmitted. The body region S3 surrounds the lens region and may have a rectangular shape.

The lens regions S1 and S2 may be circular. The lens regions S1 and S2 are divided into a first region S1 through which light for forming an image on the image sensor is transmitted and a second region S2 that does not contribute to image formation of light with respect to the image sensor. The first region S1 corresponds to the image sensor. That is, the first region S1 may have a rectangular shape, and the second region S2 is formed to surround the first region S1.

According to the present disclosure, since a FPCB 250 is disposed in the second region S2 that does not contribute to image formation, a lateral thickness of the camera module can be reduced. That is, the FPCB 250 can overlap the liquid lens unit 230 in the thickness direction so as to be disposed in the second region S2.

Referring to the drawing, the FPCB 250 is stacked (or laminated) on the liquid lens unit 230. That is, the FPCB 250 can be disposed on the top plate 232 or the bottom plate 231 of the liquid lens unit 230. In this instance, the FPCB 250 overlaps the body region S3.

The FPCB 250 can also extend along the edge of the liquid lens unit 230 when the FPCB 250 overlaps the body region S3. Accordingly, the FPCB 250 can be formed to surround the first region S1. Here, since the FPCB 250 extends to have a predetermined width, the FPCB 250 can be disposed in the second region S2 that does not contribute to image formation.

In other words, the FPCB can be positioned such that a central portion thereof is formed as a through portion to correspond to the first region S1 to cover the liquid lens part 230. In this instance, the through portion can be formed larger than the area of the first region S1. In addition, the through portion may correspond to at least a portion of each of the body region S3 and the second region S2.

The FPCB 250 can apply an electrical signal to the liquid lens unit 230 to control curvature of the liquid lens unit. In addition, the FPCB 250 may include a first FPCB 250a for applying a driving voltage and a second FPCB 250b for applying a common voltage.

In particular, the first FPCB 250a can be disposed in an upper portion of the liquid lens unit 230. Specifically, the first FPCB 250a may be stacked on the top plate 232. In this instance, the first FPCB 250a can be adhered to the top plate 232 using an adhesive, or the like.

Also, the second FPCB 250b is disposed below the liquid lens unit 230. Like the first FPCB 250a, the second FPCB 250b can be stacked on the bottom plate 231 and adhered using an adhesive, or the like. With this structure, since the FPCB 250 overlaps the liquid lens unit 230 in the thickness direction, the width of the lens assembly can be reduced. Accordingly, a lateral thickness of the camera device 200 can be reduced, reducing the total volume of the camera device 200.

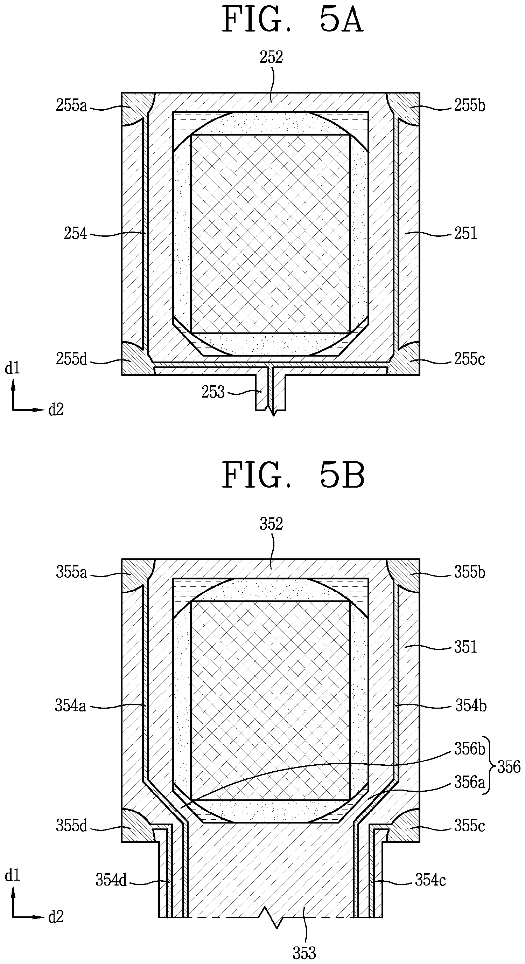

Next, FIGS. 5A and 5B are conceptual views illustrating an example of a liquid lens unit in which the FPCB illustrated in FIG. 4 is positioned. Hereinafter, embodiments according to the present disclosure will be described with reference to the drawings.

The FPCB 250 can be electrically connected to a controller to transmit an electrical signal of the controller to the liquid lens unit 230. The FPCB 250 can also have an extending portion 253 extending from a portion thereto so as to be connected to the controller. That is, the FPCB 250 may include stacked portions 251 and 252 stacked on the liquid lens unit 230 and the extending portion 253 extending from the stacked portions 251 and 252. The extending portion 253 may extend in the first direction d1.

Referring to the drawings, the FPCB 250 includes a node portion 255 and a conductive pattern 254. The node portion 255 adjusts the curvature of the liquid lens unit 230 by applying a voltage to the electrode 234. The node portion 255 may include a plurality of nodes 255a, 255b, 255c, and 255d formed at corners of the upper or lower surface of the liquid lens unit 230, respectively. Each of the plurality of nodes 255a, 255b, 255c, and 255d can be electrically connected to the conductive pattern 254 to receive an electrical signal.

For the embodiment illustrated in FIG. 5A, the plurality of nodes 255a, 255b, 255c, and 255d are connected by the single conductive pattern 254. In addition, the conductive pattern 254 can be branched from any one point and extend along the extending portion 253 so as to be connected to the controller. In this instance, the same electrical signal can be applied to each of the plurality of nodes 255a, 255b, 255c, and 255d, and thus, the camera device 200 can perform the auto-focusing function.

In contrast, for the embodiment illustrated in FIG. 5B, a plurality of nodes 355a, 355b, 355c, and 355d are electrically connected to a plurality of conductive patterns 354a, 354b, 354c, and 354d, respectively. In this embodiment, the plurality of conductive patterns 354a, 354b, 354c and 354d are formed on an FPCB 350, and here, the plurality of conductive patterns 354a, 354b, 354c and 354d are spaced apart from each other at predetermined intervals to prevent a short circuit.

In this instance, the width of the FPCB is increased. However, if the width of the FPCB is simply increased, the first region may be invaded or light may be scattered to increase a flare phenomenon. In order to solve the above-mentioned problem and to form the plurality of conductive patterns 354a, 354b, 354c, and 354d, the FPCB 350 can include an extending portion 356.

The extending portion 356 extends from the corners of stacked portions 351 and 352 toward a central portion so that overlapping portion of the stacked portions 351 and 352 and the body region S3 is increased. Thus, the width of the corner portion of the FPCB 350 may be increased. In addition, the extending portion 353 cab extend in the second direction d2 and the width thereof can be increased.

The plurality of conductive patterns 354a, 354b, 354c, and 354d can extend in the first direction d1 toward the extending portion 353. The first and fourth conductive patterns 354a and 354d are disposed to be lopsided to the first and fourth nodes 355a and 355d from the extending portion 353 and the second and third conductive patterns 354b and 354c can be disposed to be lopsided to the second and third nodes 355b and 355c from the extending portion 353.

In this instance, the first and second conductive patterns 354a and 354b may extend through the first and second extending portions 356a and 356b, respectively. With this structure, the first to fourth nodes 355a, 355b, 355c, and 355d can be respectively controlled. Accordingly, the camera device 200 can perform optical image stabilization, as well as the auto-focusing function, while the width of the FPCB 350 is prevented from being increased.

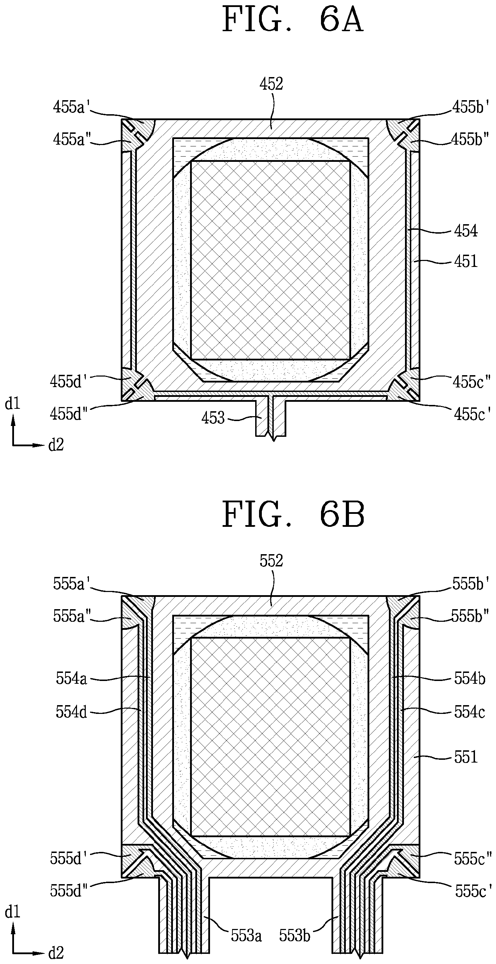

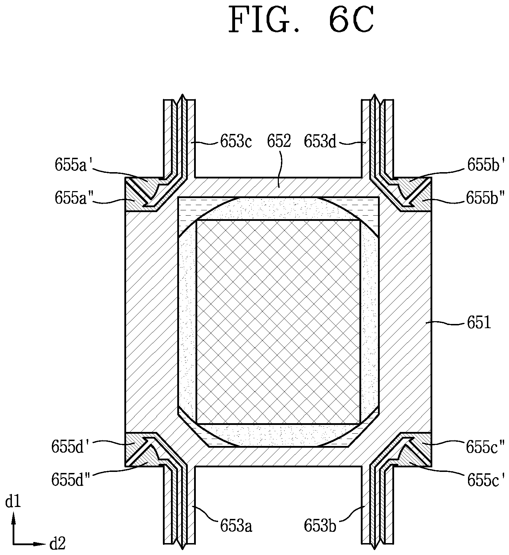

Next, FIGS. 6A, 6B, and 6C are conceptual views illustrating another example of a liquid lens unit in which the FPCB illustrated in FIG. 4A is disposed. The same or similar reference numerals are given to the components which are the same or similar to those of the above-described embodiment, and a redundant description thereof will be omitted.

Unlike the aforementioned embodiments, in this embodiment, the node portion 455 may include eight nodes 455a', 455a", 455b', 455b", 455c', 455c", 455d', and 455d". Referring to FIG. 6A, the nodes 455a', 455a", 455b', 455b", 455c', 455c", 455d', and 455d" may be arranged in pairs at the corners of a flexible circuit board 450, respectively. Also, as in the embodiment disclosed in FIG. 5A, the nodes 455a', 455a", 455b', 455b", 455c', 455c", 455d', and 455d" may be electrically connected by one conductive pattern 454. With this structure, it is possible to control the liquid lens unit 430 more minutely.

Referring to FIG. 6B, the extending portion 553 can be formed in plurality. More specifically, the extending portion 553 includes first and second extending portions 553a and 553bextending in parallel in the first direction d1. In this instance, the first and second extending portions 553a and 553b can be lopsided to one side and the other side so as to be spaced apart from each other.

Referring to FIG. 6C, a plurality of extending portions 653 may extend in directions opposite to each other. The extending portions 653 include first to fourth extending portions 653a, 653b, 653c, and 653d. The first and second extensions 653a and 653b can extend from any one side of the liquid lens unit in one direction, and the third and fourth extensions 653c and 653d can extend from the other side of the liquid lens unit in a direction opposite to the one direction. The first and second extending portions 653a and 653b and the third and fourth extending portions 653c and 653d are also spaced apart from each other.

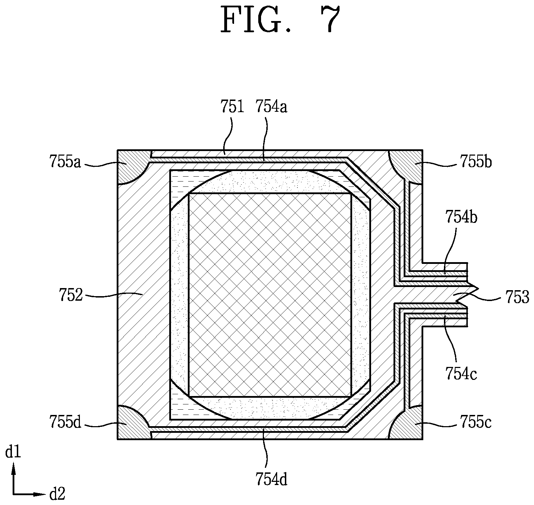

Next, FIG. 7 is a conceptual view illustrating a modification of the liquid lens unit in which the FPCB illustrated in FIG. 4A is disposed. In this embodiment, unlike the above-described embodiments, an extending portion 753 extends in the second direction d2 perpendicular to the first direction d1. Since the length of the image sensor in the first direction d1 is longer than the length of the image sensor in the second direction d2, the stacked portion 752 extending in the first direction d1 of an FPCB 750 can be formed to have a width larger than that of the stacked portion 751 extending in the second direction d2.

Accordingly, conductive patterns 754a, 754b, 754c, and 754d can be formed so as to converge toward the extending portion 753 formed at the center. When the extending portion 753 of the FPCB is assembled to a lens cover, the FPCB is bent downwards inside of the lens cover. In this instance, due to the thickness of the FPCB, the lateral thickness of the camera device is increased.

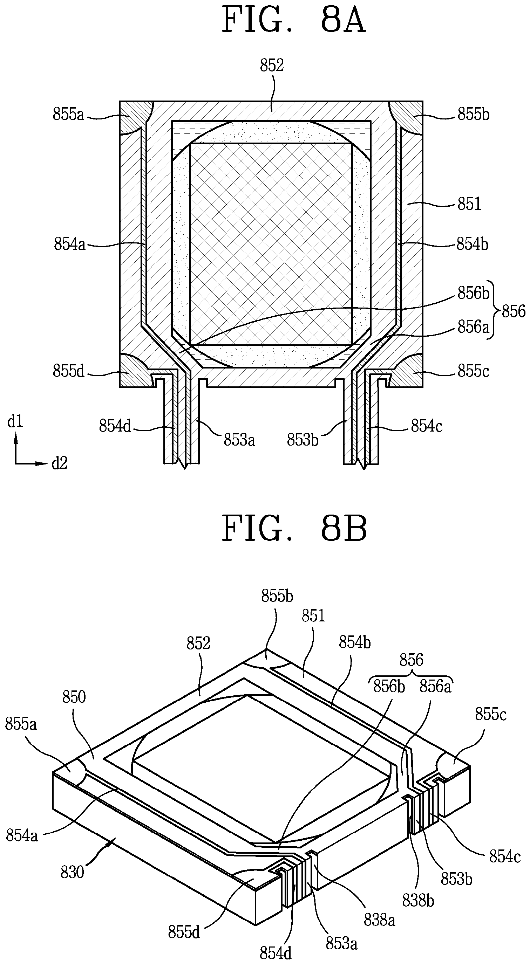

Next, FIGS. 8A and 8B are conceptual views illustrating another modification of the liquid lens unit in which the FPCB illustrated in FIG. 4A is disposed. In this embodiment, the liquid lens unit 830 includes recess portions 838 in which extending portions 853a and 853b are disposed. The recess portions 838 can be formed to be recessed from any one side of the liquid lens unit 830. In addition, the recess portions 838 extend in a vertical direction. Extending portions 853a and 853b are bent and disposed in the recess portions 838. The extending portions 853a and 853b can also be connected to an electronic circuit disposed at a lower end of the camera device.

The recessed portions 838a and 838b can be formed as a pair and formed to be lopsided to one side and the other side on the side surface of the liquid lens unit 830 to correspond to the extending portions 853a and 853b. The widths of the recessed portions 838a and 838b may be larger than the widths of the extending portions 853a and 853b. In addition, grooves corresponding to the recess portions 838a and 838b may be formed on both sides of the extending portions 853a and 853b, respectively. With this structure, it is possible to suppress an increase in the lateral thickness of the camera device which is increased due to the thickness of the FPCB.

Referring back to FIG. 2B, the camera device 200 according to an embodiment of the present disclosure may include a masking portion 270 to prevent a flare shape. The camera device 200 is configured such that light incident therein is refracted by the lens assemblies 220, 230, and 240 to form an image on the image sensor. However, a phenomenon in which at least a portion of incident light is scattered by the internal structure and scattered light is incident to the image sensor occurs. This phenomenon is known as a flare phenomenon, and in order to reduce such a flare phenomenon, the camera device 100 according to the present disclosure includes the masking portion 270.

The masking portion 270 is formed of black and can absorb scattered light. Referring to the drawing, the masking portion 270 is formed on the FPCB 250 arranged to surround the first region S1. Further, the masking portion 270 may be a tape of black color and adhered to the FPCB 250. The masking portion 270 can also be stacked on each of the first and second FPCBs 250a and 250b.

In addition, the FPCB 250 can be formed in a black color to form the masking portion 270. That is, the FPCB 250 can be formed integrally with the masking portion 270. With this structure, it is possible to reduce the phenomenon in which light scattered by the internal structure of the camera device deviates from an intended refraction path and is incident to the image sensor.

However, light passing through the liquid lens unit 230 may pass through the second lens unit 240 so as to be scattered again. A masking region can be formed in the ultraviolet cut filter 280 according to the present disclosure.

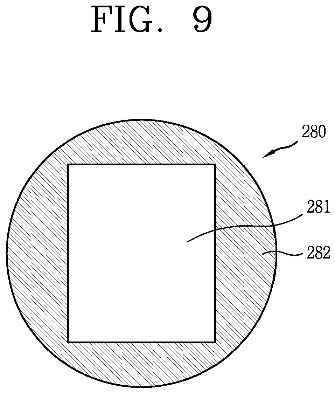

Next, FIG. 9 is a view illustrating an infrared cut filter according to the present disclosure. Referring back to FIG. 2A, the camera device 200 according to an embodiment of the present disclosure further includes an infrared cut filter 280. The infrared cut filter 280 may be disposed between the second lens unit 240 and the image sensor 260.

The infrared cut filter 280 has a flat plate shape and may include a transmissive region 281 formed to correspond to the image sensor and a masking region 282 formed to surround the transmissive region 281. The masking region 282 may be formed in a black color like the masking portion 270 described above. The flare phenomenon caused due to light scattered in the camera device can be reduced by the masking region 282 of the infrared cut filter 280 disposed in the second lens unit 240 and the image sensor 260.

The present invention described above may be implemented as a computer-readable code in a medium in which a program is recorded. The computer-readable medium includes any type of recording device in which data that may be read by a computer system is stored. The computer-readable medium may be, for example, a hard disk drive (HDD), a solid state disk (SSD), a silicon disk drive (SDD), a ROM, a RAM, a CD-ROM, a magnetic tape, a floppy disk, an optical data storage device, and the like. The computer-readable medium also includes implementations in the form of carrier waves (e.g., transmission via the Internet). Also, the computer may include the controller 180 of the terminal. Thus, the foregoing detailed description should not be interpreted limitedly in every aspect and should be considered to be illustrative. The scope of the present invention should be determined by reasonable interpretations of the attached claims and every modification within the equivalent range are included in the scope of the present invention.

The foregoing embodiments and advantages are merely exemplary and are not to be considered as limiting the present disclosure. The present teachings may be readily applied to other types of apparatuses. This description is intended to be illustrative, and not to limit the scope of the claims.

## Claims

1. A camera device (200) comprising:
a first lens unit (220) concentrating light incident from a front side;
a liquid lens unit (230) disposed on a rear side of the first lens unit and controlling an optical path of light by adjusting a curvature of the liquid lens unit according to an electrical signal;
a second lens unit (240) disposed on a rear side of the liquid lens unit;
an image sensor (260) on which light passing through the second lens unit forms an image; and
a flexible printed circuit board, FPCB (250, 350, 450, 750), transferring the electrical signal to the liquid lens unit,
**characterized in that** the liquid lens unit (230) includes:
a lens region including a first region (S1) through which light for forming an image on the image sensor is transmitted and a second region (S2) that does not contribute to image formation of light with respect to the image sensor, the second region (S2) surrounding the first region (S1), and
a body region (S3) surrounding the lens region,
wherein the FPCB (250) is disposed in the second region (S2) and overlaps the liquid lens unit (230) in a thickness direction.

2. The camera device of claim 1, wherein the FPCB (250, 350, 450, 750) surrounds the first region (S1) of the liquid lens unit (230) while being disposed in the second region (S2) of the liquid lens unit (230).

3. The camera device of claim 1 or 2, wherein the liquid lens unit (230) has an upper surface and a lower surface, and
wherein the FPCB (250, 350, 450, 750) is stacked on the upper surface or the lower surface of the liquid lens unit (230).

4. The camera device of claim 2 or 3, further comprising:
a masking portion (270) formed on the FPCB (250, 350, 450, 750) to surround the first region (S1) of the liquid lens unit (230).

5. The camera device of any one of claims 1 to 4, wherein the FPCB (250, 350, 450, 750) further comprises:
an extending portion (253, 353, 553, 653, 753, 853) branched from the FPCB (250, 350, 450, 750) and connected to a controller (180).

6. The camera device of claim 5, wherein the FPCB includes a node portion (255, 455) applying an electrical signal to the liquid lens unit (230) and a conductive pattern (254, 454) electrically connected to the node portion (255, 455), and
wherein the node portion (255, 455) includes a plurality of nodes (255a, 255b, 255c, 255d, 355a, 355b, 355c, 355d, 455a', 455a", 455b', 455b" 455c', 455c" 455d', 455d") disposed at corners of the liquid lens unit (230), respectively.

7. The camera device of claim 6, wherein the plurality of nodes (255a, 255b, 255c, 255d, 455a', 455a", 455b', 455b" 455c', 455c" 455d', 455d") are electrically connected by a single conductive pattern.

8. The camera device of claim 6 or 7, wherein the conductive pattern (354) includes a plurality of conductive patterns (354a, 354b, 354c, 354d) electrically connected to the plurality of nodes (355a, 355b, 355c, 355d), respectively,
wherein the FPCB (350) has an extending portion (356) extending from a corner of the FPCB (350), and
wherein at least a portion of the conductive pattern (354a, 354b, 354c, 354d) passes through the extending portion (356).

9. The camera device of claim 8, wherein the extending portion (553) includes a plurality of extending portions (553a, 553b) extending parallel to each other in a same direction.

10. The camera device of claim 8, wherein the extending portion (653) includes a plurality of extending portions (653a, 653b, 653c, 653d) extending in opposite directions.

11. The camera device of any one of claims 5 to 10, wherein the liquid lens unit (230) has a recess portion (838) recessed from a surface of the liquid lens unit (230), and
wherein the extending portion (853a, 833b) is disposed in the recess portion (838).

12. The camera device of any one of claims 1 to 11, further comprising:
an infrared cut filter divided into a transmissive region corresponding to the image sensor and a masking region surrounding the transmissive region.

13. An electronic device (100) comprising:
a display unit (151);
a bezel portion surrounding the display unit (151); and
a camera device (200) disposed in the bezel portion,
wherein the camera device (200) includes:
a lens cover (210) forming an appearance of the camera device and having a pair of flat surfaces facing each other;
a lens assembly (220, 230, 240) disposed inside the lens cover (210) and including a liquid lens unit controlling an optical path of light incident from a front side according to an applied electrical signal;
an image sensor (260) overlapping the lens assembly and forming an image using light passing through the lens assembly; and
a flexible printed circuit board, FPCB (250, 350, 450, 750), transferring the electrical signal to the liquid lens unit,
**characterized in that** the liquid lens unit (230) includes:
a lens region including a first region (S1) through which light for forming an image on the image sensor is transmitted and a second region (S2) that does not contribute to image formation of light with respect to the image sensor, the second region (S2) surrounding the first region (S1), and
a body region (S3) surrounding the lens region,
wherein the FPCB (250, 350, 450, 750) is disposed in the second region (S2) and overlaps the liquid lens unit (230) in a thickness direction, and
wherein one of the pair of flat surfaces facing each other is disposed adjacent to the display unit (151).

14. The electronic device of claim 13, wherein the lens assembly (220, 230, 240) includes a plurality of lenses having different diameters, and
wherein an inner circumferential surface of the lens cover (210) is stepped such that the plurality of lenses are inserted thereto.

15. The electronic device of claim 13 or 14, wherein the lens assembly (220, 230, 240) further includes a first lens unit (220) and a second lens unit (240),
wherein the lens cover (210) includes a first portion (211) accommodating the first lens unit (220) and a second portion (212) accommodating the liquid lens unit (230) and the second lens unit (240), and
wherein the first portion (211) and the second portion (212) are integrally formed.

## Patentansprüche

1. Kameravorrichtung (200) umfassend:
eine erste Linseneinheit (220), die von einer Vorderseite einfallendes Licht bündelt;
eine Flüssiglinseneinheit (230), die auf einer Rückseite der ersten Linseneinheit angeordnet ist und einen optischen Lichtpfad durch Einstellen einer Krümmung der Flüssiglinseneinheit gemäß einem elektrischen Signal steuert;
eine zweite Linseneinheit (240), die auf der Rückseite der Flüssiglinseneinheit angeordnet ist;
einen Bildsensor (260), auf dem Licht, das durch die zweite Linseneinheit fällt, ein Bild erzeugt; und
eine flexible Leiterplatte, FPCB (250, 350, 450, 750), die das elektrische Signal an die Flüssiglinseneinheit überträgt,
**dadurch gekennzeichnet, dass**
die Flüssiglinseneinheit (230) enthält:
einen Linsenbereich mit einem ersten Bereich (S1), durch den Licht zur Erzeugung eines Bildes auf dem Bildsensor übertragen wird, und einem zweiten Bereich (S2), der nicht zur Bilderzeugung aus Licht in Bezug auf den Bildsensor beiträgt, wobei der zweite Bereich (S2) den ersten Bereich (S1) umgibt, und
einen Körperbereich (S3), der den Linsenbereich umgibt,
wobei die FPCB (250) in dem zweiten Bereich (S2) angeordnet ist und die Flüssiglinseneinheit (230) in einer Dickenrichtung überlappt.

2. Kameravorrichtung nach Anspruch 1, wobei die FPCB (250, 350, 450, 750) den ersten Bereich (S1) der Flüssiglinseneinheit (230) umgibt, während sie im zweiten Bereich (S2) der Flüssiglinseneinheit (230) angeordnet ist.

3. Kameravorrichtung nach Anspruch 1 oder 2, wobei die Flüssiglinseneinheit (230) eine obere Fläche und eine untere Fläche aufweist, und
wobei die FPCB (250, 350, 450, 750) auf der oberen Fläche oder der unteren Fläche der Flüssiglinseneinheit (230) gestapelt ist.

4. Kameravorrichtung nach Anspruch 2 oder 3, ferner umfassend:
einen Maskierungsabschnitt (270), der auf dem FPCB (250, 350, 450, 750) ausgebildet ist, um den ersten Bereich (S1) der Flüssiglinseneinheit (230) zu umgeben.

5. Kameravorrichtung nach einem der Ansprüche 1 bis 4, wobei die FPCB (250, 350, 450, 750) ferner umfasst:
ein verlängerter Abschnitt (253, 353, 553, 653, 753, 853), der von der FPCB (250, 350, 450, 750) abzweigt und mit einer Steuerung (180) verbunden ist.

6. Kameravorrichtung nach Anspruch 5, wobei das FPCB einen Knotenabschnitt (255, 455), der ein elektrisches Signal an die Flüssiglinseneinheit (230) anlegt, und ein leitendes Muster (254, 454), das elektrisch mit dem Knotenabschnitt (255, 455) verbunden ist, enthält, und
wobei der Knotenabschnitt (255, 455) eine Vielzahl von Knoten (255a, 255b, 255c, 255d, 355a, 355b, 355c, 355d, 455a', 455a", 455b', 455b" 455c', 455c" 455d', 455d") aufweist, die jeweils an Ecken der Flüssiglinseneinheit (230) angeordnet sind.

7. Kameravorrichtung nach Anspruch 6, wobei die mehreren Knoten (255a, 255b, 255c, 255d, 455a', 455a", 455b', 455b" 455c', 455c" 455d', 455d") durch ein einziges leitendes Muster elektrisch verbunden sind.

8. Kameravorrichtung nach Anspruch 6 oder 7, wobei das leitende Muster (354) eine Vielzahl von leitenden Mustern (354a, 354b, 354c, 354d) umfasst, die jeweils elektrisch mit der Vielzahl von Knoten (355a, 355b, 355c, 355d) verbunden sind,
wobei die FPCB (350) einen Verlängerungsabschnitt (356) aufweist, der sich von einer Ecke der FPCB (350) aus erstreckt, und
wobei mindestens ein Teil des leitenden Musters (354a, 354b, 354c, 354d) durch den sich erstreckenden Abschnitt (356) hindurchgeht.

9. Kameravorrichtung nach Anspruch 8, wobei der Verlängerungsabschnitt (553) eine Vielzahl von Verlängerungsabschnitten (553a, 553b) aufweist, die sich parallel zueinander in derselben Richtung erstrecken.

10. Kameravorrichtung nach Anspruch 8, wobei der Verlängerungsabschnitt (653) eine Vielzahl von Verlängerungsabschnitten (653a, 653b, 653c, 653d) aufweist, die sich in entgegengesetzte Richtungen erstrecken.

11. Kameravorrichtung nach einem der Ansprüche 5 bis 10, wobei die Flüssiglinseneinheit (230) einen Aussparungsabschnitt (838) aufweist, der von einer Oberfläche der Flüssiglinseneinheit (230) zurückgesetzt ist, und
wobei der Verlängerungsabschnitt (853a, 833b) in dem Aussparungsabschnitt (838) angeordnet ist.

12. Kameravorrichtung nach einem der Ansprüche 1 bis 11, ferner umfassend:
einen Infrarot-Sperrfilter, der in einen durchlässigen Bereich, der dem Bildsensor entspricht, und einen den durchlässigen Bereich umgebenden Maskierungsbereich unterteilt ist.

13. Elektronisches Gerät (100) umfassend:
eine Anzeigeeinheit (151);
ein die Anzeigeeinheit (151) umgebendes Einfassungsteil; und
eine Kameravorrichtung (200), die im Einfassungsteil angeordnet ist,
wobei die Kameravorrichtung (200) umfasst:
eine Linsenabdeckung (210), die ein Erscheinungsbild der Kameravorrichtung bildet und ein Paar ebener, einander zugewandter Flächen aufweist;
eine Linsenanordnung (220, 230, 240), die innerhalb der Linsenabdeckung (210) angeordnet ist und eine Flüssiglinseneinheit enthält, die einen optischen Pfad von Licht, das von einer Vorderseite einfällt, gemäß einem angelegten elektrischen Signal steuert;
einen Bildsensor (260), der die Linsenanordnung überlappt und ein Bild unter Verwendung von Licht erzeugt, das durch die Linsenanordnung hindurchgeht; und
eine flexible Leiterplatte, FPCB (250, 350, 450, 750), die das elektrische Signal an die Flüssiglinseneinheit überträgt,
**dadurch gekennzeichnet, dass**
die Flüssiglinseneinheit (230) enthält:
einen Linsenbereich mit einem ersten Bereich (S1), durch den Licht zur Erzeugung eines Bildes auf dem Bildsensor übertragen wird, und einem zweiten Bereich (S2), der nicht zur Bilderzeugung aus Licht in Bezug auf den Bildsensor beiträgt, wobei der zweite Bereich (S2) den ersten Bereich (S1) umgibt, und
einen Körperbereich (S3), der den Linsenbereich umgibt,
wobei die FPCB (250) in dem zweiten Bereich (S2) angeordnet ist und die Flüssiglinseneinheit (230) in einer Dickenrichtung überlappt, und
wobei eine Fläche des ebenen, sich einander zugewandten Flächenpaars angrenzend an die Anzeigeeinheit (151) angeordnet ist.

14. Elektronisches Gerät nach Anspruch 13, wobei die Linsenanordnung (220, 230, 240) eine Vielzahl von Linsen mit unterschiedlichen Durchmessern enthält, und
wobei eine innere Umfangsfläche der Linsenabdeckung (210) so abgestuft ist, dass die Vielzahl von Linsen darin eingesetzt ist.

15. Elektronisches Gerät nach Anspruch 13 oder 14, wobei die Linsenanordnung (220, 230, 240) ferner eine erste Linseneinheit (220) und eine zweite Linseneinheit (240) umfasst,
wobei die Linsenabdeckung (210) einen ersten Abschnitt (211), der die erste Linseneinheit (220) aufnimmt, und einen zweiten Abschnitt (212), der die Flüssiglinseneinheit (230) und die zweite Linseneinheit (240) aufnimmt, aufweist, und
wobei der erste Abschnitt (211) und der zweite Abschnitt (212) einstückig ausgebildet sind.

## Revendications

1. Dispositif de caméra (200) comprenant :
une première unité de lentilles (220) concentrant la lumière incidente provenant d'une face avant ;
une unité de lentille liquide (230) disposée sur une face arrière de la première unité de lentilles et commandant un chemin optique de lumière par réglage d'une courbure de l'unité de lentille liquide selon un signal électrique ;
une seconde unité de lentilles (240) disposée sur une face arrière de l'unité de lentille liquide ;
un capteur d'image (260) sur lequel la lumière traversant la seconde unité de lentilles forme une image ; et
une carte de circuit imprimé souple, FPCB (250, 350, 450, 750), transférant le signal électrique à l'unité de lentille liquide,
**caractérisé en ce que**
l'unité de lentille liquide (230) comprend :
une région de lentille comprenant une première région (S1) par laquelle la lumière pour former une image sur le capteur d'image est transmise et une seconde région (S2) qui ne contribue pas à la formation d'image de lumière par rapport au capteur d'image, la seconde région (S2) entourant la première région (S1), et
une région de corps (S3) entourant la région de lentille,
la FPCB (250) étant disposée dans la seconde région (S2) et chevauchant l'unité de lentille liquide (230) dans le sens de l'épaisseur.

2. Dispositif de caméra selon la revendication 1, la FPCB (250, 350, 450, 750) entourant la première région (S1) de l'unité de lentille liquide (230) tandis qu'elle est disposée dans la seconde région (S2) de l'unité de lentille liquide (230).

3. Dispositif de caméra selon la revendication 1 ou la revendication 2, l'unité de lentille liquide (230) ayant une face supérieure et une face inférieure, et
la FPCB (250, 350, 450, 750) étant empilée sur la face supérieure ou la face inférieure de l'unité de lentille liquide (230).

4. Dispositif de caméra selon la revendication 2 ou la revendication 3, comprenant en outre :
une partie de masque (270) formée sur la FPBC (250, 350, 450, 750) pour entourer la première région (S1) de l'unité de lentille liquide (230).

5. Dispositif de caméra selon l'une quelconque des revendications 1 à 4, la FPCB (250, 350, 450, 750) comprenant en outre :
une partie d'extension (253, 353, 553, 653, 753, 853) branchée à partir de la FPCB (250, 350, 450, 750) et connectée à un organe de commande (180).

6. Dispositif de caméra selon la revendication 5, la FPCB comprenant une partie de nœud (255, 455) appliquant un signal électrique à l'unité de lentille liquide (230) et une impression conductrice (254, 454) connectée électriquement à la partie de nœud (255, 455), et
la partie de nœud (255, 455) comprenant une pluralité de nœuds (255a, 255b, 255c, 255d, 355a, 355b, 355c, 455a', 455a", 455b', 455b", 455c', 455c", 455d', 455d") disposés dans les coins de l'unité de lentille liquide (230), respectivement.

7. Dispositif de caméra selon la revendication 6, la pluralité de nœuds (255a, 255b, 255c, 255d, 455a', 455a", 455b', 455b", 455c', 455c", 455d', 455d") étant électriquement connectés par une impression conductrice unique.

8. Dispositif de caméra selon la revendication 6 ou la revendication 7, l'impression conductrice (354) comprenant une pluralité d'impressions conductrices (354a, 354b, 354c, 354d) connectées électriquement à la pluralité de nœuds (355a, 355b, 355c, 355d), respectivement,
la FPCB (350) ayant une partie d'extension (356) partant d'un coin de la FPCB (350), et
au moins une partie de l'impression conductrice (354a, 354b, 354c, 354d) traversant la partie d'extension (356).

9. Dispositif de caméra selon la revendication 8, la partie d'extension (553) comprenant une pluralité de parties d'extension (553a, 553b) étant parallèles l'une avec l'autre dans la même direction.

10. Dispositif de caméra selon la revendication 8, la partie d'extension (653) comprenant une pluralité de parties d'extension (653a, 653b, 653c, 653d) partant dans des directions opposées.

11. Dispositif de caméra selon l'une quelconque des revendications 5 à 10, l'unité de lentille liquide (230) ayant une partie creuse (838) en retrait dans une face de l'unité de lentille liquide (230), et
la partie d'extension (853a, 853b) étant disposée dans la partie creuse (838).

12. Dispositif de caméra selon l'une quelconque des revendications 1 à 11, comprenant en outre :
un filtre infrarouge divisé en une région transmissive correspondante au capteur d'image et une région de masque entourant la région transmissive.

13. Dispositif électronique (100) comprenant :
une unité d'affichage (151) ;
une partie cadre frontal entourant l'unité d'affichage (151) ; et
un dispositif de caméra (200) disposé dans la partie cadre frontal,
le dispositif de caméra (200) comprenant :
un couvercle de lentille (210) formant une apparence du dispositif de caméra et ayant une paire de faces plates se faisant face ;
un ensemble lentilles (220, 230, 240) disposé à l'intérieur du couvercle de lentille (210) et comprenant une unité de lentille liquide commandant un chemin optique de lumière provenant d'une face avant selon un signal électrique appliqué ;
un capteur d'image (260) chevauchant l'ensemble lentilles et formant une image à l'aide de la lumière traversant l'ensemble lentilles ; et
une carte de circuit imprimé souple, FPCB (250, 350, 450, 750), transférant le signal électrique à l'unité de lentille liquide,
**caractérisé en ce que**
l'unité de lentille liquide (230) comprend :
une région de lentille comprenant une première région (S1) par laquelle la lumière pour former une image sur le capteur d'image est transmise et une seconde région (S2) qui ne contribue pas à la formation d'image de lumière par rapport au capteur d'image, la seconde région (S2) entourant la première région (S1), et
une région de corps (S3) entourant la région de lentille,
la FPCB (250) étant disposée dans la seconde région (S2) et chevauchant l'unité de lentille liquide (230) dans le sens de l'épaisseur, et
une face plate de la paire de faces plates se faisant face étant adjacentes à l'unité d'affichage (151).

14. Dispositif électronique selon la revendication 13, l'ensemble lentille (220, 230, 240) comprenant une pluralité de lentilles ayant différents diamètres, et
une face circonférentielle intérieure du couvercle de lentille (210) étant étagée de sorte que la pluralité de lentille y soit insérée.

15. Dispositif électronique selon la revendication 13 ou la revendication 14, l'ensemble lentille (220, 230, 240) comprenant en outre une première unité de lentille (220) et une seconde unité de lentille (240),
le couvercle de lentille (210) comprenant une première partie (211) logeant la première unité de lentille (220) et une seconde partie (212) logeant l'unité de lentille liquide (23) et la seconde unité de lentille (240), et
la première partie (211) et la seconde partie (212) étant formées d'un seul tenant.
